# EUROPEAN PATENT APPLICATION

(11) **EP 4 790 430 A1**
(43) Date of publication of application: **12.08.2026**
(21) Application number: 26156024.7
(22) Date of filing: 03.02.2026
(51) Int. Cl.: G01R 19/00, G01R 19/32

(54) **TEMPERATURE COMPENSATION FOR CURRENT TRANSFORMER METERING**

(30) Priority: 11.02.2025 US 202519050677
(71) Applicant: Schneider Electric USA, Inc., Boston, MA 02108 (US)
(72) Inventor: CARELOCK, James Edward, Boston, 02108 (US)
(74) Representative: Openshaw & Co.

(57) **Abstract**

A system and method of determining temperature compensated current for current transformer (CT) metering are provided. A CT assembly (130) having a temperature sensor (210) mounted within a housing (138) enables the measurement of temperature of the CT. A printed circuit board assembly (142) of the CT transmits the current and temperature to a trip unit (304). The trip unit (304) both displays the measurements, and calculates a temperature compensated current. The trip unit (304) may trip a breaker (300) or generate alerts based on temperature measurements within one or more CT assemblies or based on variance in the current between multiple CT assemblies.

## Description

### BACKGROUND

Conventional circuit breakers often include multiple poles, each of which includes a current transformer (CT). While CTs include sensors to measure current, the current measured within the CT may not be precise or accurate due to the impact of temperature within the unit. Conventional circuit breakers also often include a trip unit, which can trip the breaker in response to the current passing through one of the poles exceeding a predetermined threshold; however, this may be based on the more imprecise current measurement within the CT. While the current measurement obtained through the CT may often be sufficient for safety decisions, such as when to trip the breaker, the measurement may lack sufficient precision due to temperature within the current assembly for other equipment requiring higher accuracy.

Frequently, breakers do not include a temperature sensor, but even when a temperature sensor is present, the sensor measures temperature within the breaker unit assembly rather than the temperature within any of the CT assemblies. While the temperature of the breaker unit may match the temperature within the CT assembly or assemblies when the breaker is unloaded, when the breaker is loaded the temperature of the CT assembly or assemblies will differ from that of the breaker. Further, without individual measurement of temperature within each of the CT assemblies, conventional breakers cannot identify whether there is a variance of temperature between the CTs. A variance of temperature within the CTs can indicate that the resistance of the breaker must be checked or other issues with the breaker. Further, without measuring the temperature within the CT, the trip unit cannot provide the most accurate measurement of current for the CT.

### SUMMARY

Aspects of the present disclosure provide a temperature compensated current measurement for CT metering. A sensor enclosed within the CT assembly measures the temperature near the CT. A trip unit receives the temperature measurement and calculates a temperature compensated current. Because of the temperature measurement, the trip unit responds to temperature related events occurring within the CT. Further, the trip unit provides more accurate current measurement using the temperature compensated current measurement.

In one aspect, a system for temperature compensation in transformer current metering includes a CT assembly. The CT assembly includes a CT configured to generate a current signal representative of a current in a conductor passing through a core of the CT, a housing enclosing the CT, and a temperature sensor associated with the CT. The temperature sensor is enclosed within the housing. The system also includes a trip unit communicatively coupled to the CT and the trip unit includes a processor and a memory. The memory stores computer-executable instructions that, when executed by the processor, configure the trip unit for receiving a temperature measurement from the temperature sensor, the temperature measurement indicative of a temperature within the housing of the CT. The executed instructions also include receiving a current signal from the CT and calculating a temperature compensated current measurement based on the temperature measurement and the current measurement.

In another aspect, a method for measuring temperature compensated current includes generating a temperature measurement, by a temperature sensor in an assembly of a CT, the temperature measurement indicative of a temperature within the housing of the CT, wherein the CT is configured to generate a current signal representative of a current in a conductor passing through a core of the CT. The method also includes transmitting, to a trip unit, a current signal of the CT and the temperature measurement generated by the temperature sensor and calculating, by the trip unit, a temperature compensated current based on the current signal and the temperature measurement.

In yet another aspect, a CT assembly comprises a CT configured to generate a current signal representative of a current in a conductor passing through a core of the CT, a housing enclosing the CT, and a temperature sensor associated with the CT, the temperature sensor enclosed within the housing and configured to generate a temperature measurement indicative of a temperature of the CT.

Other objects and features of the present invention will be in part apparent and in part pointed out herein.

### BRIEF DESCRIPTION OF THE DRAWINGS

FIG. 1 illustrates a perspective view of a CT according to an embodiment.
FIG. 2A is a perspective view of a PCBA (printed circuit board assembly) and the core of a CT according to an embodiment.
FIG. 2B is an image of the interior of a CT assembly having a PCBA according to an embodiment.
FIG. 3 is a schematic diagram of a breaker unit according to an embodiment.
FIG. 4A is an image showing four poles of a breaker unit according to an embodiment.
FIG. 4B is an image showing four CT assemblies each corresponding to a pole of a breaker according to an embodiment.
FIG. 5 is a flow diagram illustrating the process of determining a temperature compensated current according to an embodiment.
FIG. 6A is a graph illustrating the error percentage of current measurement without temperature compensation.
FIG. 6B is a graph illustrating the error percentage of current measurement with temperature compensation.

Corresponding reference characters indicate corresponding parts throughout the drawings.

### DETAILED DESCRIPTION

The features and other details of the concepts, systems, and techniques sought to be protected herein will now be more particularly described. It will be understood that any specific embodiments described herein are shown by way of illustration and not as limitations of the disclosure and the concepts described herein. Features of the subject matter described herein can be employed in various embodiments without departing from the scope of the concepts sought to be protected.

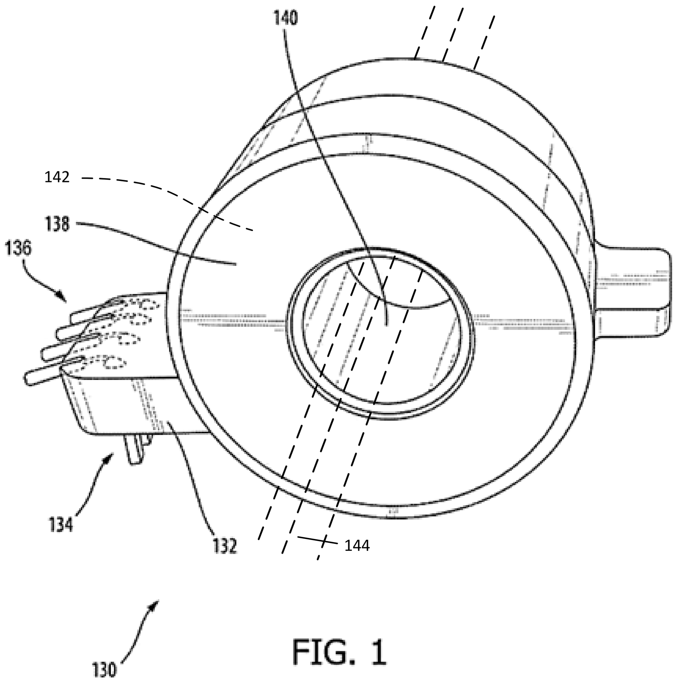

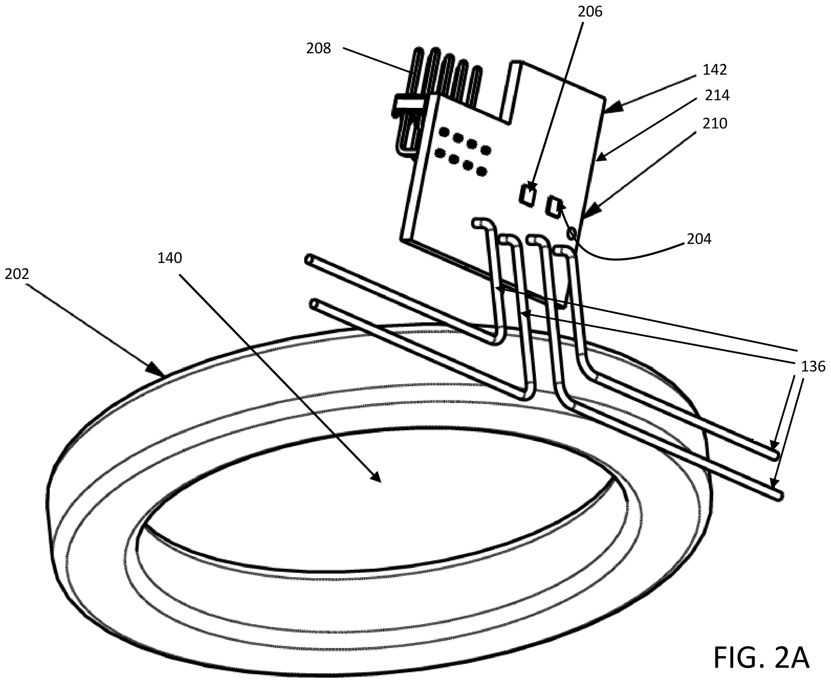

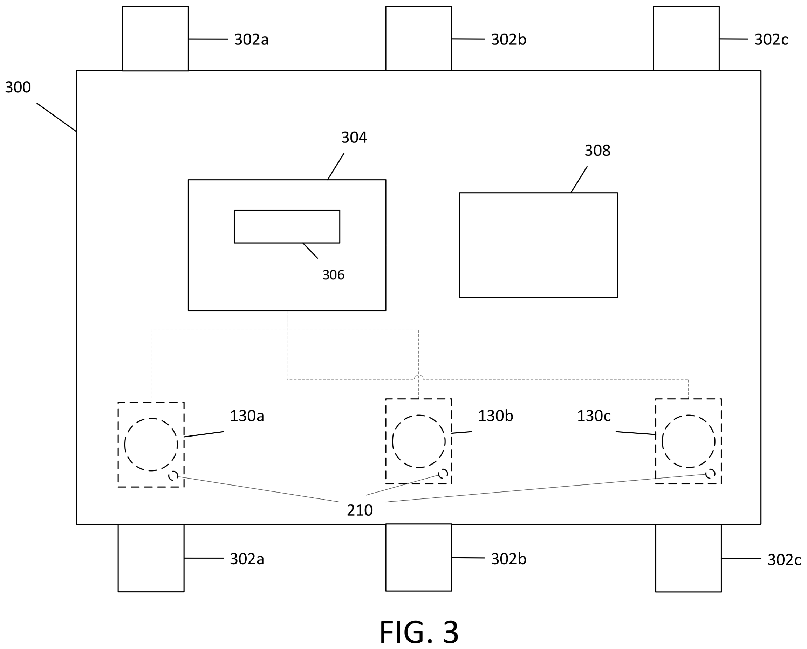

FIG. 1 illustrates an embodiment of a CT assembly 130 according to aspects of the present disclosure. As shown in FIG. 1, the CT assembly 130 is embodied by a CT for use in a breaker unit, which is further described below (see FIG. 3). The CT acts as a current sensor for the conductor 144 passing through the central opening 140, which may be in/through a CT core 202 (FIG. 2A). The CT is configured to generate a current signal representative of a current in the conductor 144. In other embodiments, the CT assembly 130 is embodied for use in other forms of electrical protective device. The device may be a device or portion thereof configured to perform at least one operation, including a Miniature Circuit Breaker (MCB), a Ground Fault Circuit Interrupter (GFCI), or other electronic device or portion thereof in various embodiments, or may be a device or portion of a device configured to perform one or more operations corresponding to a GFCI. The CT assembly 130 can be any suitable shape (e.g., a polygonal closed shape, a circular or toroidal closed shape, etc.). For example, CT assembly 130 comprises a circular or toroidal closed shape CT as shown in FIG. 1.

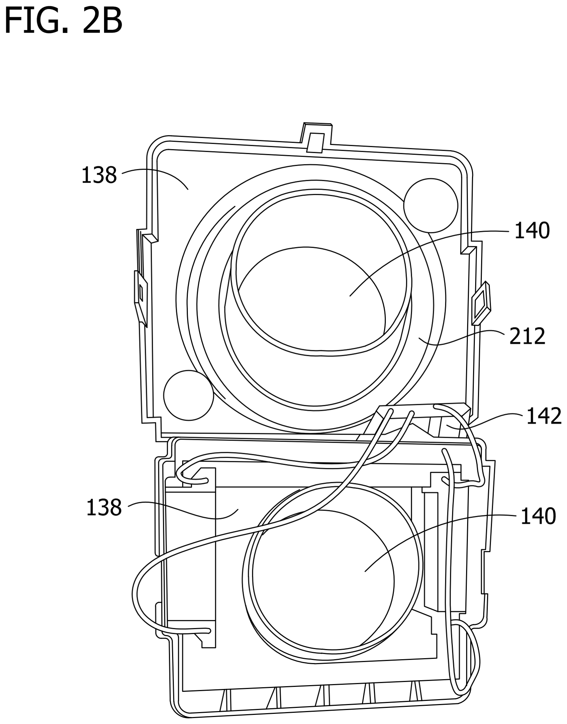

In certain embodiments, CT assembly 130 of FIG. 1 embodied as a CT includes multiple wire terminations 136, a housing 138, and a central opening 140 through the housing 138 and the CT's core 202 (see FIG. 2A). In certain embodiments, the wire terminations 136 may be coupled to a plurality of pins in various configurations. Moreover, though FIG. 1 shows wire terminations 136 being external to the CT assembly 130, the wire terminations 136 may be inside the CT assembly 130 in some embodiments. For example, the wire terminations 136 may be inside the housing 138 that is shown in FIG. 2B. In the illustrated embodiment, CT assembly 130 has a PCBA 142 mounted directly on CT assembly 130 as shown in FIG. 2B. The PCBA 142 contains sensor electronics and includes a connector 208 (e.g., having multiple pins, see FIG. 2A).

FIG. 2A illustrates the PCBA 142 along with the core 202 on which a coil is wound (see FIG. 2B) according to one embodiment. The PCBA 142 includes a memory 204 and processor 206 for storing and processing instructions including instructions to monitor the temperature and current, and calculate the temperature compensated current. The wire terminations 136 of CT assembly 130 and the connector 208 of PCBA 142 may be connected together such that each wire termination 136 is connected to a respective pin on the connector 208. The connector 208 provides a means to communicate signals to the rest of the breaker unit (e.g., to a trip unit 304 thereof (FIG. 3)). Accordingly, signals can be communicated between the PCBA 142 and the breaker unit via the wire terminations 136. These signals may include, for example, temperature signals and current signals. In the present embodiment, the CT assembly 130 has a temperature sensor 210 mounted directly within the CT assembly 130 as shown in FIG. 1. In some embodiments, the temperature sensor 210 is associated with a CT by being mounted directly to the CT itself. For example, the temperature sensor 210 may be fixed to the CT itself, for example using glue or some other suitable adhesive, to obtain the most accurate temperature of the CT (see FIG. 2). In another embodiment, the temperature sensor 210 is associated with a CT by being mounted within the housing 138 of the CT. The temperature sensor 210 connects to (e.g., is communicatively coupled to) the PCBA 142. For example, the temperature sensor 210 may be on (e.g., part of) the PCBA 142. Moreover, the temperature sensor 210 and a current sensor 214 of the CT assembly 130 may, in some embodiments, share (e.g., both be on/part of) the same PCBA 142. In some embodiments, the temperature sensor 210 comprises a thermocouple, a thermistor, or resistance temperature detector (RTD).

In certain embodiments, two wire terminations 136 can be connected to opposing ends of a sense winding or coil 212 (see FIG. 2B) wrapping around the CT core 202 contained within the housing 138 of sensor 130. The opening 140 of sensor 130 may be configured to permit one or more conductors 144 and/or other conductor(s) or components (or portions thereof)) to pass at least partially therethrough. At least a portion of one or more of the conductors 144 is configured to pass through the opening 140 of CT assembly 130. It should be appreciated that any number of conductors 144 may be configured to pass through at least a portion of the opening 140 in various embodiments without departing from the scope of this disclosure.

Turning now to FIG. 2B, FIG. 2B is an image showing the interior of a CT assembly 130 according to an embodiment. As shown in in FIG. 2B, the housing 138 has been opened to show the coil 212 of the CT wrapped around the core. Thus, a conductor may pass through the CT assembly 130 through the opening of the housing 140. Further, as illustrated the PCBA 142 may be mounted within the housing. The temperature sensor 210 may be mounted within the housing 138 at locations on the coil 212 of the CT itself or on the PCBA 142 as shown in FIG. 2B.

FIG. 3 illustrates a breaker unit 300 according to an embodiment. As illustrated in FIG. 3, the breaker includes three poles 302a, 302b, 302c. The breaker has three CT assemblies 130a, 130b, 130c respectively in line with the poles 302a, 302b, 302c. Thus a conductor 144 passes through each of the CT assemblies 130a, 130b, 130c. While illustrated with three poles 302a, 302b, 302c and three CT assemblies 130a, 130b, 130c, it will be noted that the breaker unit 300 may include any number of (e.g., four, six, or eight) poles 302 and CT assemblies 130. In some embodiments, each of the CT assemblies 130a, 130b, 130c includes an internal temperature sensor 210. Accordingly, one temperature sensor 210 can be used per pole 302. Thus, the temperature within each of the CT assemblies 130a, 130b, 130c can be measured independently close to the point of current measurement. By monitoring temperature at each of the poles 302a, 302b, 302c, an individual high heat status for a pole can be detected regardless of the temperature of the other poles or the breaker as a whole. Further, a temperature adjusted current measurement can be calculated for each of the poles 302a, 302b, 302c based on the temperature measured within the CT. For example, a suitable breaker unit 300 for use with integrated temperature sensor 210 may be embodied by a PowerPacT P/R, a MasterPacT NT/NW, or a MasterPacT MTZ from Schneider Electric.

In the present embodiment, the breaker unit 300 also includes trip unit 304. In one embodiment, the trip unit 304 may be alternatively referred to as a control unit. In some embodiments, the trip unit 304 includes a microprocessor and circuitry configured to receive sensor measurements from the PCBA 142 of one or more CT assemblies 130a, 130b, 130c. The trip unit 304 connectively couples to one or more of the PCBAs 142 of the CT assemblies 130a, 130b, 130c. In one embodiment, the trip unit 304 includes sensor electronics, such as an analog to digital converter (ADC) for converting the temperature signal received from the temperature sensor 210. In some embodiments, each CT assembly 130a, 130b, 130c has its own PCBA 142 internally. In other embodiments only one CT assembly 130a, for example, has a PCBA 142. Thus, the PCBA 142 of CT 130a receives the sensor measurements of the other CT assemblies 130b, 130c to relay to the trip unit 304. As illustrated in FIG. 3, in some embodiments, the trip unit 304 includes a display 306. The display 306 enables the trip unit 302 to show measurements received from the PCBA 142 of the CT assemblies 130a, 130b, 130c.

The trip unit 304 further connects to the breaker 308 of the breaker unit 300. In some embodiments, the breaker 308 may be referred to as the electromagnetic trip chain. The breaker 308, when tripped, prevents the flow of current through the breaker unit. In some embodiments, the trip unit 304 trips the breaker 308 in response to a current measurement exceeding a predetermined threshold. In one embodiment, the predetermined threshold is configured on the trip unit 304 by an operator. In another embodiment, the trip unit 304 produces an alert on the display 306 in response to a measurement of CT assemblies 130a, 130b, 130c exceeding a predetermined threshold.

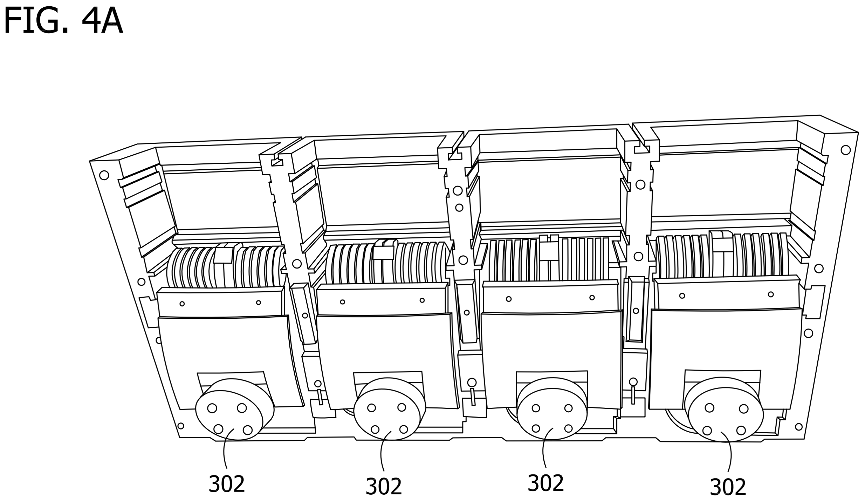

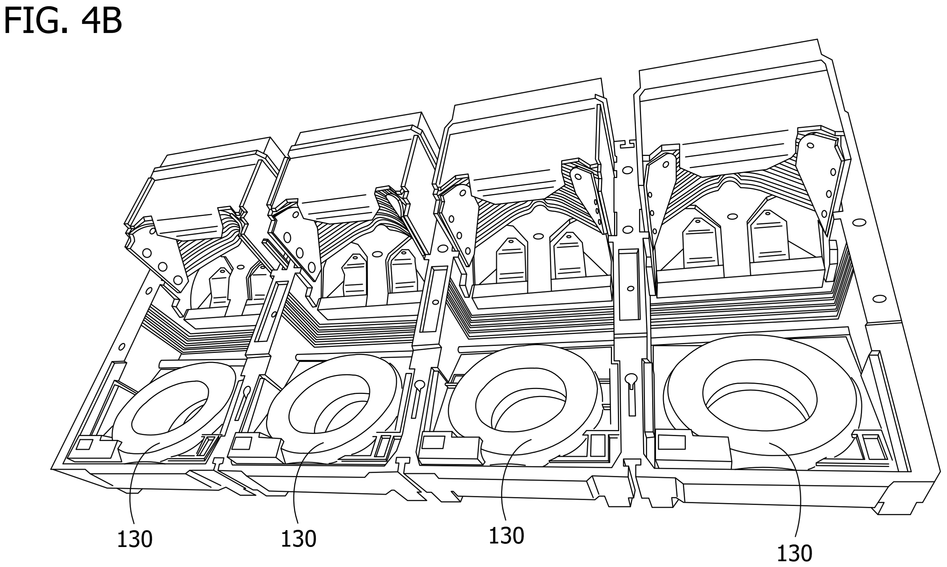

FIG. 4A is an image showing four poles 302 of a breaker unit 300 (see FIG. 3) according to an embodiment. FIG. 4B is an image showing four CT assemblies 130 within the poles 302 of a breaker unit 300 according to an embodiment. As illustrated, the breaker unit 300 has four poles 302, however a breaker having any number of poles 302 may implement a temperature sensor 210 within the CT assembly 130.

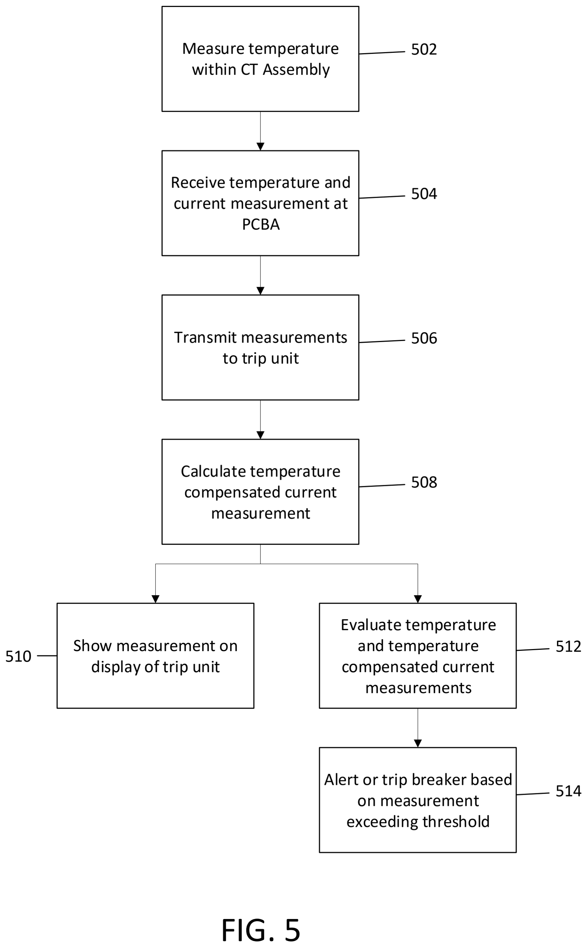

FIG. 5 is a flow diagram illustrating one embodiment of a process for determining a temperature compensated current within one or more CT assemblies 130a, 130b, 130c. At step 502, a temperature sensor 210 enclosed within each CT assembly measures the temperature within its respective CT assembly. By measuring the temperature within the CT assembly, the temperature measurement accurately indicates the temperature proximate to the CT sense coil 212 within the housing 138. Next at step 504, the PCBA 142 receives the temperature measurements from each of the temperature sensors 210 and receives the current measurement of each of the CT assemblies 130a, 130b, 130c. Then the PCBA 142 transmits the temperature and current measurements to the trip unit 304 at step 506. The trip unit 304 receives the temperature and current measurements (e.g., temperature and current signals, respectively) from the PCBA 142.

The trip unit 304 calculates a temperature compensated current measurement based on the temperature and current measurements (e.g., temperature and current signals, respectively) at step 508. For each CT assembly 130, the trip unit 304 calculates a temperature compensated current based upon its respective temperature measurement and current measurement. In some embodiments, the temperature compensated current measurement is calculated through a matrix method. In other embodiments, the temperature compensated current measurement is calculated through a polynomial method. In some embodiments, the trip unit 304 shows each temperature compensated current measurement on its display 306 at step 510. By calculating an individual temperature compensated current measurement, the trip unit 304 provides accurate measurement current for equipment connected to each of the respective poles 302a, 302b, 302c of a breaker unit 300.

In one embodiment, next at step 512, the trip unit 304 evaluates the temperatures of the CTs and the temperature compensated currents. In some embodiments, the trip unit 304 triggers an alarm or trips the breaker 308 in response to evaluation of the temperatures or the temperature compensated currents at step 514. In one embodiment, the trip unit 304 triggers an alarm in response to the temperature of any individual CT 130 exceeding a predetermined threshold and/or sends a signal to the display 306 indicating a high heat status. In another embodiment, the trip unit 304 triggers the breaker 308 through sending a trip signal in response to the temperature of any individual CT exceeding a predetermined threshold. In yet another embodiment, the trip 304 unit triggers an alarm in response to the temperature compensated current of any individual CT exceeding a predetermined threshold. In other embodiments, the trip unit 304 triggers an alert and/or the breaker 308 through a trip signal in response to an imbalance in the temperature measurements of multiple CTs 130a, 130b, 130c. For example, assuming electrical balance between the poles 302, if one pole 302a is 5% (or more) higher in temperature than other poles 302b, 302c, then the trip signal can be transmitted in response to such imbalance. Thus, the trip unit 304 compares the temperature of one CT to the temperature of another CT to determine if the difference exceeds a predetermined threshold. In still other embodiments, the trip unit 304 sends an alert in response to the difference in the temperature compensated currents of multiple CTs 130a, 130b, 130c exceeding a predetermined threshold.

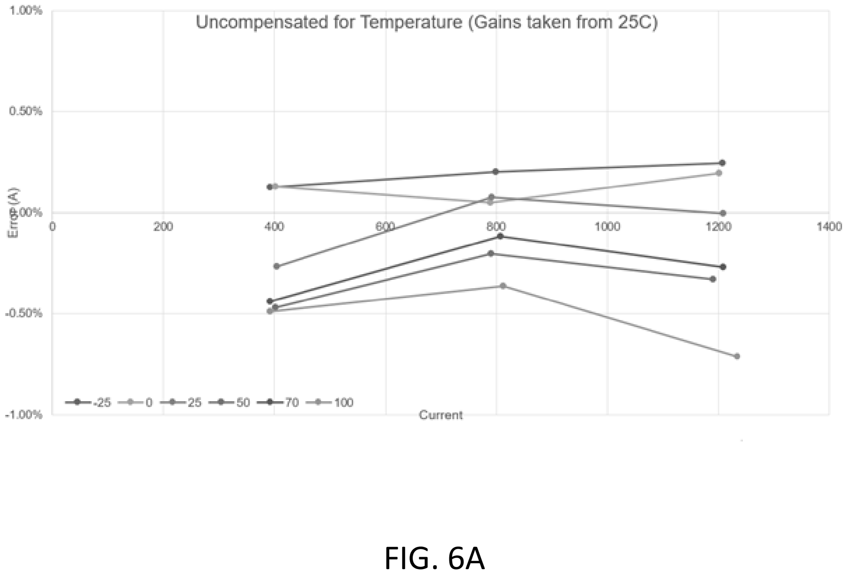

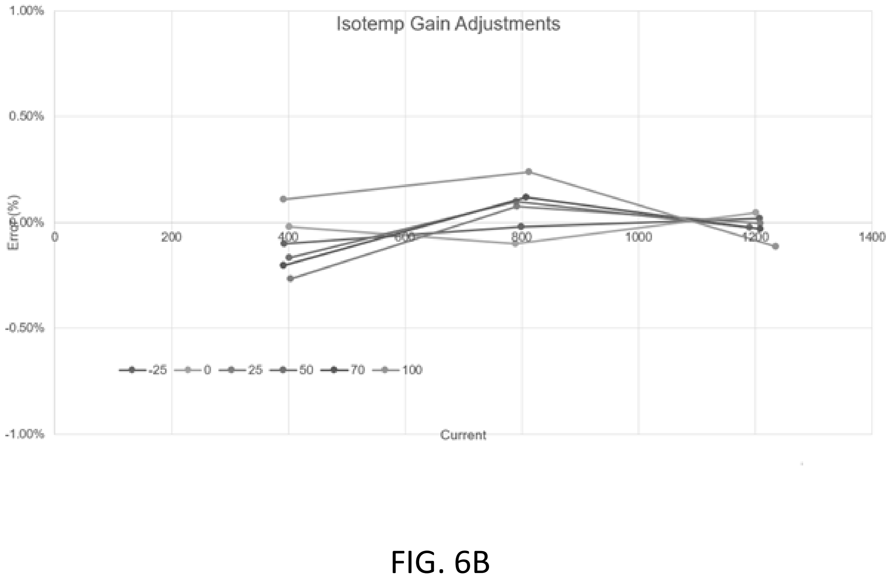

FIGS. 6A and 6B are graphs illustrating the improved accuracy resulting from calculating a temperature compensated current within the trip unit 304. FIG. 6A shows the error between the uncompensated current measurement from within the CT and an external current measurement (x-axis), over a set of test currents (y-axis). The various test currents were evaluated at a range of temperatures from -25 degrees Celsius up to 100 degrees Celsius. FIG. 6B shows the same test measurement, with a comparison between the temperature compensated current measurement to the external current measurement. As can be seen by comparing the two charts, the temperature compensated current measurement produces a more accurate measurement (e.g., for power metering) than just the current measurement from the CT itself provides. By providing more accurate current measurement from the trip unit, equipment with higher current sensitivity and/or requiring a higher level of precision can better operate with the CT assemblies 130 including an internal temperature sensor 210.

Embodiments of the present disclosure may comprise a special purpose computer including a variety of computer hardware, as described in greater detail herein.

For purposes of illustration, programs and other executable program components may be shown as discrete blocks. It is recognized, however, that such programs and components reside at various times in different storage components of a computing device, and are executed by a data processor(s) of the device.

Embodiments of the aspects of the present disclosure may be described in the general context of data and/or processor-executable instructions, such as program modules, stored one or more tangible, non-transitory storage media and executed by one or more processors or other devices. Generally, program modules include, but are not limited to, routines, programs, objects, components, and data structures that perform particular tasks or implement particular abstract data types. Aspects of the present disclosure may also be practiced in distributed computing environments where tasks are performed by remote processing devices that are linked through a communications network. In a distributed computing environment, program modules may be located in both local and remote storage media including memory storage devices.

Embodiments may be implemented with processor-executable instructions. The processor-executable instructions may be organized into one or more processor-executable components or modules on a tangible processor readable storage medium. Also, embodiments may be implemented with any number and organization of such components or modules. For example, aspects of the present disclosure are not limited to the specific processor-executable instructions or the specific components or modules illustrated in the figures and described herein. Other embodiments may include different processor-executable instructions or components having more or less functionality than illustrated and described herein.

The order of execution or performance of the operations in accordance with aspects of the present disclosure illustrated and described herein is not essential, unless otherwise specified. That is, the operations may be performed in any order, unless otherwise specified, and embodiments may include additional or fewer operations than those disclosed herein. For example, it is contemplated that executing or performing a particular operation before, contemporaneously with, or after another operation is within the scope of the invention.

When introducing elements of the invention or embodiments thereof, the articles "a," "an," "the," and "said" are intended to mean that there are one or more of the elements. The terms "comprising," "including," and "having" are intended to be inclusive and mean that there may be additional elements other than the listed elements.

Not all of the depicted components illustrated or described may be required. In addition, some implementations and embodiments may include additional components. Variations in the arrangement and type of the components may be made without departing from the scope of the claims as set forth herein. Additional, different or fewer components may be provided and components may be combined. Alternatively, or in addition, a component may be implemented by several components.

The above description illustrates embodiments by way of example and not by way of limitation. This description enables one skilled in the art to make and use aspects of the invention, and describes several embodiments, adaptations, variations, alternatives and uses of the aspects of the invention, including what is presently believed to be the best mode of carrying out the aspects of the invention. Additionally, it is to be understood that the aspects of the invention are not limited in its application to the details of construction and the arrangement of components set forth in the following description or illustrated in the drawings. The aspects of the invention are capable of other embodiments and of being practiced or carried out in various ways. Also, it will be understood that the phraseology and terminology used herein is for the purpose of description and should not be regarded as limiting.

It will be apparent that modifications and variations are possible without departing from the scope of the invention defined in the appended claims. As various changes could be made in the above constructions and methods without departing from the scope of the invention, it is intended that all matter contained in the above description and shown in the accompanying drawings shall be interpreted as illustrative and not in a limiting sense.

In view of the above, it will be seen that several advantages of the aspects of the invention are achieved and other advantageous results attained.

The Abstract and Summary are provided to help the reader quickly ascertain the nature of the technical disclosure. They are submitted with the understanding that they will not be used to interpret or limit the scope or meaning of the claims. The Summary is provided to introduce a selection of concepts in simplified form that are further described in the Detailed Description. The Summary is not intended to identify key features or essential features of the claimed subject matter, nor is it intended to be used as an aid in determining the claimed subject matter.

Further aspects of the invention are provided by the subject matter of the following clauses:
Clause 1. A system for temperature compensation in transformer current metering, the system comprising: a current transformer (CT) assembly comprising: a CT configured to generate a current signal representative of a current in a conductor passing through a core of the CT; a housing enclosing the CT; and a temperature sensor associated with the CT, the temperature sensor enclosed within the housing; a trip unit communicatively coupled to the CT, the trip unit comprising: a processor; and a memory coupled to the processor, the memory storing computer-executable instructions that, when executed by the processor, configure the trip unit for: receiving a temperature measurement from the temperature sensor, the temperature measurement indicative of a temperature of the CT;
   receiving the current signal from the CT; and calculating a temperature compensated current measurement based on the temperature measurement and the current signal.
Clause 2. The system of Clause 1, wherein the trip unit comprises a display and wherein the memory stores computer-executable instructions that, when executed by the processor, further configure the trip unit for: displaying, on the display of the trip unit, the temperature compensated current measurement.
Clause 3. The system of Clause 2, wherein the memory stores computer-executable instructions that, when executed by the processor, further configure the trip unit for: alerting a high heat status on the display of the trip unit in response to the temperature measurement exceeding a predetermined threshold.
Clause 4. The system of any of Clauses 1 to 3, wherein the system further comprises a breaker communicatively coupled to the trip unit, the breaker configured to receive a trip signal from the trip unit to prevent a flow of current in response thereto, and wherein the memory stores computer-executable instructions that, when executed by the processor, further configure the trip unit for: sending, by the trip unit, the trip signal to the breaker in response to the temperature compensated current measurement exceeding a predetermined threshold.
Clause 5. The system of Clause 4, wherein the memory stores computer-executable instructions that, when executed by the processor, further configure the trip unit for: sending, by the trip unit, a second trip signal to the breaker in response to the temperature measurement exceeding a predetermined threshold.
Clause 6. The system of any of Clauses 1 to 5, wherein the CT comprises a first CT, the housing comprises a first housing, and the temperature sensor comprises a first temperature sensor configured to provide a first temperature measurement, the system further comprising: a second CT assembly comprising: a second CT configured to generate a second current signal representative of a current in a conductor passing through a core of the second CT; a second housing enclosing the CT; and a second temperature sensor associated with the second CT, the second temperature sensor enclosed within the second housing.
Clause 7. The system of Clause 6, wherein the memory stores computer-executable instructions that, when executed by the processor, further configure the trip unit for: receiving a second temperature measurement from the second temperature sensor, the second temperature measurement indicative of a temperature of the second CT; comparing the first temperature measurement from the first temperature sensor to the second temperature measurement from the second temperature sensor; and generating a temperature imbalance alert in response to an imbalance between the first temperature measurement and the second temperature measurement.
Clause 8. The system of any of Clauses 1 to 7, wherein the temperature sensor comprises at least one of a thermocouple, thermistor, or a resistance temperature detector.
Clause 9. The system of any of Clauses 1 to 8, wherein the temperature sensor is configured to generate a temperature signal indicative of the temperature of the CT and further comprising a printed circuit board assembly (PCBA) on the housing of the CT assembly, the PCBA communicatively coupled to the temperature sensor and having sensor electronics thereon configured to generate the temperature measurement from the temperature signal.
Clause 10. A method for measuring temperature compensated current, the method comprising: generating a temperature measurement, by a temperature sensor in an assembly of a current transformer (CT), the temperature measurement indicative of a temperature within the housing of the CT, wherein the CT is configured to generate a current signal representative of a current in a conductor passing through a core of the CT; transmitting, to a trip unit, the current signal generated by the CT and the temperature measurement generated by the temperature sensor; and calculating, by the trip unit, a temperature compensated current based on the current signal and the temperature measurement.
Clause 11. The method of Clause 10, further comprising: displaying the temperature compensated current on a display of the trip unit.
Clause 12. The method of Clause 10 or Clause 11, further comprising: displaying a high heat status on a display of the trip unit in response to the temperature measurement exceeding a predetermined threshold.
Clause 13. The method of any of Clauses 10 to 12, further comprising: sending, by the trip unit, a trip signal to a breaker in response to the temperature compensated current measurement exceeding a predetermined threshold, the breaker configured to receive the trip signal to prevent a flow of current.
Clause 14. The method of Clause 13 further comprising: sending, by the trip unit, a second trip signal to the breaker in response to the temperature measurement exceeding a predetermined threshold.
Clause 15. The method of any of Clauses 10 to 14, wherein the temperature measurement comprises a first temperature measurement generated by a first temperature sensor in a first assembly of a first CT, the method further comprising: generating a second temperature measurement, by a second temperature sensor in a second assembly of a second CT, the second temperature measurement indicative of a temperature within a second housing of the second CT, wherein the second CT is configured to generate a second current signal representative of a current in a conductor passing through a core of the second CT;
   transmitting, to a trip unit, the second current signal generated by the second CT and the second temperature measurement generated by the second temperature sensor; comparing the first temperature measurement from the first temperature sensor to the second temperature measurement from the second temperature sensor; and generating a temperature imbalance alert in response to an imbalance between the first temperature measurement and the second temperature measurement.
Clause 16. The method of Clause 15, further comprising calculating, by the trip unit, a second temperature compensated current based on the second current signal and the second temperature measurement.
Clause 17. A current transformer (CT) assembly comprising: a CT configured to generate a current signal representative of a current in a conductor passing through a core of the CT; a housing enclosing the CT; and a temperature sensor associated with the CT, the temperature sensor enclosed within the housing and configured to generate a temperature measurement indicative of a temperature of the CT.
Clause 18. The CT assembly of Clause 17, further comprising a printed circuit board assembly (PCBA) enclosed within the housing, the PCBA communicatively coupled to the temperature sensor and having sensor electronics thereon configured to generate the temperature measurement.
Clause 19. The CT assembly of Clause 18, wherein the CT comprises a current sensor, the current sensor communicatively coupled to the PCBA, and wherein the current sensor and the temperature sensor are both on the PCBA.
Clause 20. The CT assembly of any of Clauses 17 to 19, wherein the temperature sensor comprises at least one of a thermocouple, thermistor, or a resistance temperature detector.

## Claims

1. A system for temperature compensation in transformer current metering, the system comprising:
a current transformer, CT, assembly (130) comprising:
a CT configured to generate a current signal representative of a current in a conductor (144) passing through a core (202) of the CT;
a housing (138) enclosing the CT; and
a temperature sensor (210) associated with the CT, the temperature sensor (210) being enclosed within the housing (138); and
a trip unit (304) communicatively coupled to the CT, the trip unit (304) comprising:
a processor; and
a memory coupled to the processor, the memory storing computer-executable instructions that, when executed by the processor, configure the trip unit (304) for:
receiving a temperature measurement from the temperature sensor (210), the temperature measurement being indicative of a temperature of the CT;
receiving the current signal from the CT; and
calculating a temperature compensated current measurement based on the temperature measurement and the current signal.

2. The system of claim 1, wherein the trip unit (304) comprises a display (306) and wherein the memory stores computer-executable instructions that, when executed by the processor, configure the trip unit (304) for:
displaying, on the display (306) of the trip unit (304), the temperature compensated current measurement.

3. The system of claim 2, wherein the memory stores computer-executable instructions that, when executed by the processor, configure the trip unit (304) for:
alerting a high heat status on the display (306) of the trip unit (304) in response to the temperature measurement exceeding a predetermined threshold.

4. The system of any of claims 1 to 3, wherein the system comprises a breaker (300) communicatively coupled to the trip unit (304), the breaker (300) being configured to receive a trip signal from the trip unit (304) to prevent a flow of current in response thereto, and wherein the memory stores computer-executable instructions that, when executed by the processor, configure the trip unit (304) for:
sending, by the trip unit (304), the trip signal to the breaker (300) in response to the temperature compensated current measurement exceeding a predetermined threshold.

5. The system of claim 4, wherein the memory stores computer-executable instructions that, when executed by the processor, configure the trip unit (304) for:
sending, by the trip unit (304), a second trip signal to the breaker (300) in response to the temperature measurement exceeding a predetermined threshold.

6. The system of any of claims 1 to 5, wherein the CT comprises a first CT, the housing (138) comprises a first housing (138), and the temperature sensor (210) comprises a first temperature sensor (210) configured to provide a first temperature measurement, the system further comprising:
a second CT assembly (130) comprising:
a second CT configured to generate a second current signal representative of a current in a conductor (144) passing through a core (202) of the second CT;
a second housing (138) enclosing the CT; and
a second temperature sensor (210) associated with the second CT, the second temperature sensor (210) being enclosed within the second housing (138).

7. The system of claim 6, wherein the memory stores computer-executable instructions that, when executed by the processor, configure the trip unit (304) for:
receiving a second temperature measurement from the second temperature sensor (210), the second temperature measurement being indicative of a temperature of the second CT;
comparing the first temperature measurement from the first temperature sensor (210) to the second temperature measurement from the second temperature sensor (210); and
generating a temperature imbalance alert in response to an imbalance between the first temperature measurement and the second temperature measurement.

8. The system of any of claims 1 to 7, wherein the temperature sensor (210) comprises at least one of a thermocouple, a thermistor, or a resistance temperature detector.

9. The system of any of claims 1 to 8, wherein the temperature sensor (210) is configured to generate a temperature signal indicative of the temperature of the CT, the system comprising a printed circuit board assembly, PCBA, (142) on the housing (138) of the CT assembly (130), the PCBA (142) being communicatively coupled to the temperature sensor (210) and having sensor electronics thereon configured to generate the temperature measurement from the temperature signal.

10. A method for measuring temperature compensated current, the method comprising:
generating a temperature measurement by a temperature sensor (210) in an assembly of a current transformer, CT, the temperature measurement being indicative of a temperature within the housing (138) of the CT, wherein the CT is configured to generate a current signal representative of a current in a conductor (144) passing through a core (202) of the CT;
transmitting, to a trip unit (304), the current signal generated by the CT and the temperature measurement generated by the temperature sensor (210); and
calculating, by the trip unit (304), a temperature compensated current based on the current signal and the temperature measurement.

11. The method of claim 10, comprising:
displaying the temperature compensated current on a display (306) of the trip unit (304).

12. A current transformer, CT, assembly (130), the CT assembly (130) comprising:
a CT configured to generate a current signal representative of a current in a conductor (144) passing through a core (202) of the CT;
a housing (138) enclosing the CT; and
a temperature sensor (210) associated with the CT, the temperature sensor (210) being enclosed within the housing (138) and configured to generate a temperature measurement indicative of a temperature of the CT.

13. The CT assembly (130) of claim 12, comprising a printed circuit board assembly, PCBA, (142) enclosed within the housing (138), the PCBA (142) being communicatively coupled to the temperature sensor (210) and having sensor electronics thereon configured to generate the temperature measurement.

14. The CT assembly (130) of claim 13, wherein the CT comprises a current sensor, the current sensor being communicatively coupled to the PCBA (142), and
wherein the current sensor and the temperature sensor (210) are both on the PCBA (142).

15. The CT assembly (130) of any of claims 12 to 14, wherein the temperature sensor (210) comprises at least one of a thermocouple, a thermistor, or a resistance temperature detector.
